# DEMANDE DE BREVET EUROPEEN

(11) **EP 4 753 341 A1**
(43) Date de publication de la demande: **03.06.2026**
(21) Numéro de dépôt: 25219996.3
(22) Date de dépôt: 02.12.2025
(51) Int. Cl.: H04W 52/24, G06N 20/10, H04W 52/38, H04W 52/42, G06F 30/27, G06N 3/0464, H04W 24/02, G06N 3/045, G06N 3/08, H04W 52/28

(54) **PROCÉDÉ DE CONTRÔLE DE LA CONFIGURATION D'UN SYSTÈME DE COMMUNICATION D'UNE PLATEFORME ET SYSTÈMES ASSOCIÉS**

(30) Priorité: 02.12.2024 FR 2413293
(71) Demandeur: THALES, 92190 Meudon (FR)
(72) Inventeur: HUBERT, William, 49309 CHOLET (FR); LADJELATE, Bilal, 91767 PALAISEAU (FR); CRAMBERT, Philippe, 92622 GENNEVILLIERS CEDEX (FR)
(74) Mandataire: Lavoix

(57) **Abrégé**

La présente invention concerne un procédé de contrôle d'un système de communication d'une plateforme, chaque système de communication de la plateforme étant configurable selon plusieurs configurations, le procédé de contrôle comprenant les étapes suivantes :
- acquisition d'une pluralité de données environnementales,
- application d'une fonction de configuration sur la pluralité de données environnementales et des paramètres relatifs à chaque système de communication de la plateforme pour obtenir des paramètres de configuration définissant une configuration pour un système de communication de la plateforme, et
- contrôle d'un système de communication de la plateforme pour que le système de communication contrôlé soit configuré selon la configuration obtenue à l'issue de l'étape d'application.

## Description

La présente invention concerne un procédé de contrôle d'un système de communication d'une plateforme. Elle porte également sur un système de contrôle associé et une plateforme comportant un tel système de contrôle.

Dans le domaine de communication entre antennes de deux plateformes, il est souhaitable de pouvoir paramétrer au plus juste les paramètres de liaison pour s'assurer d'envoyer le signal le plus adapté à la situation de communication notamment en matière de puissance d'émission ou de sélection d'antenne.

Les paramètres de liaison impliqués dans une communication sont nombreux et conduisent à utiliser de multiples modèles différents pour déterminer quelle valeur de paramètres de liaison permettent d'optimiser la communication.

A titre d'exemple, on utilisera un modèle pour obtenir le diagramme de rayonnement d'une antenne, un autre modèle pour estimer la puissance d'émission, encore un autre modèle pour calculer la propagation, ou un modèle de la performance d'une fonction d'onde en fonction du rapport signal sur bruit et d'une qualité de service visée.

En outre, les modèles utilisés présentent encore des imperfections liées au fait qu'il est difficile de prendre en considération les variations de l'environnement dans lequel la plateforme est utilisée.

Il existe donc un besoin pour un procédé de contrôle d'un système de communication d'une plateforme permettant d'obtenir une communication entre deux plateformes qui présente de meilleures performances.

A cet effet, la description concerne un procédé de contrôle d'un système de communication d'une plateforme, chaque système de communication de la plateforme étant configurable selon plusieurs configurations, le procédé de contrôle comprenant les étapes suivantes :
- acquisition d'une pluralité de données environnementales,
- application d'une fonction de configuration sur la pluralité de données environnementales et des paramètres relatifs à chaque système de communication de la plateforme pour obtenir des paramètres de configuration définissant une configuration pour un système de communication de la plateforme,
   la fonction de configuration ayant été obtenue par mise en œuvre d'un apprentissage pour que la communication réalisée avec la configuration obtenue en sortie de la fonction de configuration respecte au moins une contrainte prédéfinie, et
- contrôle d'un système de communication de la plateforme pour que le système de communication contrôlé soit configuré selon la configuration obtenue à l'issue de l'étape d'application.

Suivant d'autres aspects avantageux, le procédé de contrôle comprend une ou plusieurs des caractéristiques suivantes, prises isolément ou suivant toutes les combinaisons techniquement possibles :
- les paramètres de configuration comprennent un choix du système de communication à contrôler lorsque la plateforme comporte plusieurs systèmes de communication, la fréquence d'émission d'une onde par le système de communication à contrôler et la puissance d'émission du système de communication à contrôler et la forme d'onde du système de communication à contrôler.
- chaque système de communication comprend une pluralité d'éléments, les paramètres relatifs à chaque système de communication de la plateforme comprennent la disposition des éléments, les pertes introduites par les éléments et les performances des éléments.
- la pluralité d'éléments d'un système de communication comporte une antenne, un amplificateur et un coupleur.
- les données environnementales sont des données météorologiques ou des données relatives à un objet évoluant dans un environnement de la plateforme
- la fonction de configuration est obtenue par un apprentissage réalisé sur des données synthétiques.
- la fonction de configuration est un réseau de neurones comportant des couches de convolution, une couche de regroupement et des couches linéaires.
- une contrainte prédéfinie est une contrainte de limitation de la puissance émise par chaque système de communication.
- le procédé comporte, en outre, les étapes de :
   - obtention d'au moins une donnée de retour, une donnée de retour étant une donnée représentative de la qualité de la communication, et
   - affinement de la fonction de configuration en fonction de la donnée de retour obtenue, pour obtenir une fonction de configuration affinée.
   - dans lequel les étapes du procédé sont mises en œuvre de manière itérative, la fonction de configuration utilisée à une itération étant la fonction de configuration affinée obtenue à l'itération précédente.
- l'itération suivante est mise en œuvre uniquement si un critère est respecté, le critère étant une comparaison entre une différence entre la donnée de retour obtenue et la donnée de retour obtenue à l'itération précédente et un seuil prédéfini.
- la donnée de retour est une donnée représentative de la qualité du signal de communication transmis.

La description concerne également un système de contrôle d'un système de communication d'une plateforme, chaque système de communication de la plateforme étant configurable selon plusieurs configurations, le système de contrôle étant propre à :
- acquérir une pluralité de données environnementales,
- appliquer une fonction de configuration sur la pluralité de données environnementales et des paramètres relatifs à chaque système de communication de la plateforme pour obtenir des paramètres de configuration définissant une configuration pour un système de communication de la plateforme,
   la fonction de configuration ayant été obtenue par mise en œuvre d'un apprentissage pour que la communication réalisée avec la configuration obtenue en sortie de la fonction de configuration respecte au moins une contrainte prédéfinie, et
- contrôler un système de communication de la plateforme pour que le système de communication contrôlé soit configuré selon la configuration obtenue après application de la fonction de configuration.

La description concerne également une plateforme comprenant un système de contrôle tel que précédemment décrit.

Dans la présente description, l'expression « propre à » signifie indifféremment « adapté pour », « adapté à » ou « configuré pour ».

L'invention apparaîtra plus clairement à la lecture de la description qui va suivre, donnée uniquement à titre d'exemple non limitatif, et faite en référence aux dessins dans lesquels :
- la figure 1 est une représentation schématique de deux plateformes,
- la figure 2 est un ordinogramme d'un exemple de mise en œuvre d'un procédé de contrôle de la communication entre deux antennes des plateformes de la figure 1, et
- la figure 3 est un exemple de fonction de configuration utilisée dans le procédé de contrôle de la figure 2.

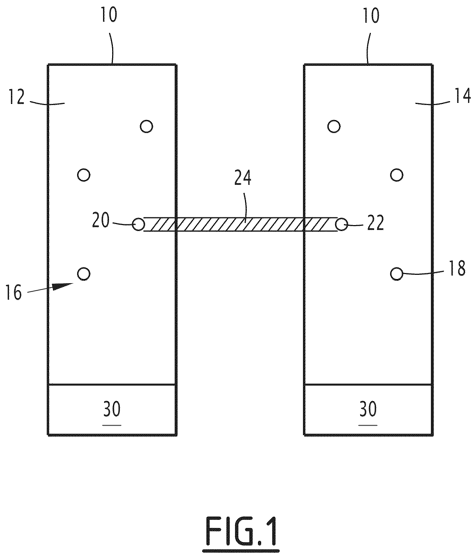

Sur la figure 1, deux plateformes 10 sont représentées, à savoir une première plateforme 12 et une deuxième plateforme 14.

Chaque plateforme 10 est typiquement destinée à tout type d'environnement terrestre, maritime et/ou aérien.

La plateforme 10 est typiquement un navire.

En variante, la plateforme 10 est un aéronef tel qu'un avion, un hélicoptère, ou un drone.

Selon encore une autre variante, la plateforme 10 est un véhicule terrestre.

Selon l'exemple décrit, chaque plateforme 10 comporte une pluralité de systèmes de communication 16 comportant, comme son nom l'indique au moins deux systèmes de communication 18.

Toutefois, dans des modes de réalisation spécifiques, il est possible de considérer des cas où l'une ou chacune des plateformes 10 comporte un seul système de communication 16.

Pour le présent cas, il est supposé que la pluralité de systèmes de communication 16 comporte au moins un système de communication faisant partie de la première plateforme 12 propre à émettre un signal de communication à destination de la deuxième plateforme 14 et un système de communication faisant partie de la deuxième plateforme 12 propre à recevoir le signal de communication ainsi émis.

Pour la suite, à titre non limitatif, il est supposé qu'un système de communication émetteur 20 de la première plateforme 12 communique avec un système de communication récepteur 22 de la deuxième plateforme 14.

Le système de communication émetteur 20 et le système de communication récepteur 22 sont propres à communiquer via un canal de transmission 24.

Le canal de transmission 24 est formé par l'ensemble des éléments de l'environnement intervenant dans la propagation d'un signal émis par le système de communication émetteur 20 à direction du système de communication récepteur 22.

Ainsi, le canal de transmission 24 dépend notamment des éléments de masquage de l'environnement mais aussi des interactions entre le signal émis et l'atmosphère ou la surface de la mer pour le cas d'une plateforme 10 qui est un navire.

Le canal de transmission 24 présente ainsi une fonction de réponse à un signal émis qui évolue donc au cours du temps en fonction de l'environnement.

Les performances de la communication entre les deux plateformes 12 et 14 dépend fortement du canal de transmission 24.

Pour optimiser au mieux ces performances au regard de contraintes prédéfinies, chaque plateforme 12 et 14 est munie d'un système de contrôle 30 permettant de configurer chaque système de communication 18.

Avant de détailler le fonctionnement du système de contrôle, il convient de préciser que, dans ce qui est présenté dans la suite, la description sera focalisée sur le contrôle des systèmes de communication 18 de la première plateforme 12, étant entendu qu'un contrôle similaire pourrait être mis en œuvre pour les systèmes de communication 18 de la première plateforme 14.

Chaque système de communication 18 de la première plateforme 10 est configurable selon plusieurs configurations.

Une configuration correspond ici à un réglage de chaque élément du système de communication 18.

En effet, chaque système de communication 18 comporte une pluralité d'éléments qui peuvent chacun opérer selon un point de fonctionnement spécifique.

Par exemple, le système de communication 18 comporte une antenne, un amplificateur, un coupleur ou un dispositif de contrôle de l'antenne.

Chacun de ces éléments peut être réglé pour obtenir un fonctionnement souhaité pour le système de communication 18.

La manière dont communique chaque système de communication 18 est ainsi réglable.

Chacun de ces degrés de liberté correspond à un paramètre de configuration.

Les paramètres de configuration définissent ainsi une configuration pour un système de communication 18 de la première plateforme 10.

A titre d'exemple, un paramètre de configuration est le choix du système de communication 18 qui doit émettre lorsque la première plateforme 12 comporte plusieurs systèmes de communication 18.

Un autre exemple de paramètre est la fréquence d'émission d'une onde émise par le système de communication 18.

Encore un autre exemple, un paramètre de configuration est la puissance d'émission du système de communication 18 choisi pour émettre.

Selon encore un autre exemple, la forme d'onde émise par le système de communication 18 est un paramètre de configuration.

Un autre exemple de paramètre de configuration est le type de modulation utilisée par le système de communication 18.

Encore un autre exemple d'un tel paramètre de configuration est le rendement de codage pour une liaison numérique.

Selon les modes de réalisation, un ou plusieurs de ces exemples forment l'ensemble des paramètres de configuration.

Le système de contrôle 30 est propre à contrôler la configuration des systèmes de communication 18 en déterminant la valeur adaptée d'un ou plusieurs (de préférence tous) des paramètres de configuration d'un système de communication 18 de la première plateforme 12.

Le système de contrôle 30 est un circuit électronique conçu pour manipuler et/ou transformer des données représentées par des quantités électroniques ou physiques dans des registres du calculateur et/ou des mémoires en d'autres données similaires correspondant à des données physiques dans les mémoires de registres ou d'autres types de dispositifs d'affichage, de dispositifs de transmission ou de dispositifs de mémorisation.

En tant qu'exemples spécifiques, le calculateur 50 est réalisé sous forme d'un composant logique programmable, tel qu'un FPGA (de l'anglais *Field Program Gate Array*), ou encore d'un circuit intégré, tel qu'un ASIC (de l'anglais *Application Specific Integrated Circuit*)
En variante, lorsque le procédé est réalisé sous forme d'un ou plusieurs logiciels, c'est-à-dire dire sous forme d'un programme d'ordinateur, également appelé produit programme d'ordinateur, il est en outre apte à être enregistré sur un support, non représenté, lisible par ordinateur. Le support lisible par ordinateur est par exemple un medium apte à mémoriser des instructions électroniques et à être couplé à un bus d'un système informatique. A titre d'exemple, le support lisible est un disque optique, un disque magnéto-optique, une mémoire ROM, une mémoire RAM, tout type de mémoire non-volatile (par exemple FLASH ou NVRAM) ou une carte magnétique. Sur le support lisible est alors mémorisé un programme d'ordinateur comprenant des instructions logicielles.

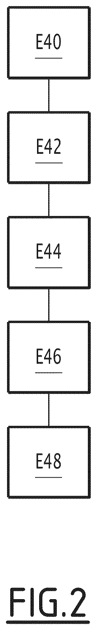

Le rôle du système de contrôle 30 est maintenant décrit au regard de la figure 2 qui illustre un exemple de fonctionnement du système de contrôle 30.

Plus précisément, la figure 2 illustre un ordinogramme d'un exemple de mise en œuvre d'un procédé de contrôle du système de communication 22 (et par là de la valeur des paramètres de configuration).

Dans l'exemple illustré, le procédé de contrôle correspond à une phase d'utilisation réalisée à bord de la première plateforme 12 par le système de contrôle 30.

Sa mise en œuvre suppose qu'une phase d'apprentissage a été réalisée précédemment.

La phase d'apprentissage est généralement réalisée hors ligne.

La phase d'apprentissage vise à déterminer une fonction de configuration des systèmes de communication 18 de la première plateforme 10.

La fonction de configuration est une fonction qui donne à partir de données environnementales et de paramètres relatifs à chaque système de communication de la première plateforme des paramètres de configuration.

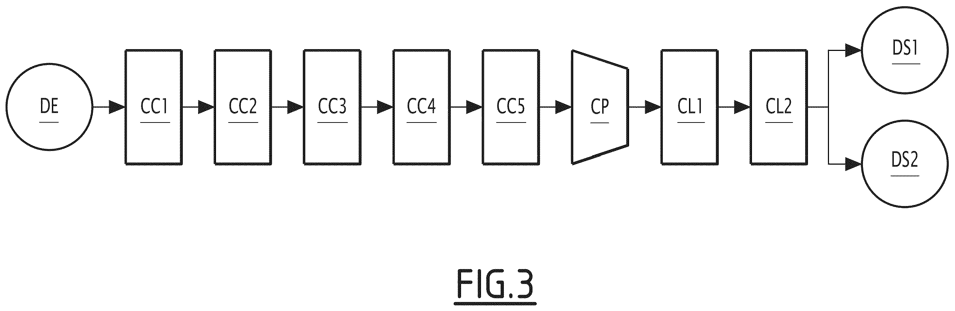

Cela est représenté schématiquement sur la figure 3, dans laquelle les données d'entrée sont notée DE et les données de sortie sont notées DS1 et DS2.

A titre d'exemple, la première donnée de sortie est le choix du système de communication et la deuxième donnée de sortie DS2 est la puissance de sortie de l'antenne du système de communication choisie.

Par définition, une donnée environnementale est une donnée relative à l'environnement de la scène observée, notamment une donnée météorologique ou une donnée relative à un objet évoluant dans la scène.

La pluralité de données environnementales comprend, par exemple, un volume de précipitations, une humidité extérieure à la plateforme et une pression atmosphérique.

Toutefois, d'autres données environnementales peuvent être envisagées, comme une altitude de la plateforme, un profil de réfraction, une température extérieure, notamment une température de l'air ou une température de l'eau, une humidité extérieure, une vitesse du vent, un volume de précipitations, un état de la mer ou encore une pression extérieure.

Les données environnementales sont avantageusement une combinaison de l'un des exemples précédents.

Les paramètres relatifs à un système de communication 18 de la première plateforme 12 sont des paramètres caractérisant chaque élément du système de communication 18 qui indépendant des données environnementales.

Par exemple, le nombre de systèmes de communication 18 ou le type d'antenne ne dépendent pas de l'environnement et définissent structurellement le système de communication 18.

Plus généralement, les paramètres relatifs à un système de communication 18 comprennent la disposition des éléments, les pertes introduites par les éléments et les performances des éléments.

Par performance dans ce contexte, il est entendu les performances intrinsèques, typiquement le gain effectif d'un amplificateur.

La fonction de configuration donne en sortie une configuration pour que la communication réalisée avec cette configuration respecte au moins une contrainte prédéfinie.

Un exemple de contrainte prédéfinie est une qualité de communication ou une limitation de la puissance émise par chaque système de communication (discrétion).

De préférence, plusieurs contraintes prédéfinies sont utilisées.

La fonction de configuration est ici un modèle d'apprentissage machine (plus communément dénommée selon la dénomination anglaise correspondante de « *machine learning* »), c'est-à-dire un module obtenu par mise en œuvre d'un apprentissage.

L'apprentissage est un apprentissage supervisé appliqué à des données d'entraînement.

Ces données d'entraînement sont des données le plus souvent synthétiques.

Les données synthétiques sont, par exemple, générés à partir d'une ou plusieurs des informations suivantes :
- une métrique de qualité de la liaison, typiquement le taux de perte de paquets pour une liaison numérique,
- la localisation des deux plateformes 12 et 14,
- les données météorologiques et d'état de mer (ou données environnementales),
- l'attitude de la plateforme 12,
- une image satellite de la zone dans laquelle les deux plateformes 12 et 14 évoluent, et
- un bilan de liaison calculé à l'aide d'un modèle de propagation.

Dans l'exemple décrit, la fonction de configuration est un réseau de neurones tel que schématiquement illustré par la figure 3.

Avant d'expliciter le réseau de neurones spécifique utilisé ici, il est intéressant de rappeler quelques généralités sur les réseaux de neurones.

Un réseau de neurones comporte une succession ordonnée de couches de neurones dont chacune prend ses entrées sur les sorties de la couche précédente.

Plus précisément, chaque couche comprend des neurones prenant leurs entrées sur les sorties des neurones de la couche précédente, ou bien sur les variables d'entrée pour la première couche.

En variante, des structures de réseaux de neurones plus complexes peuvent être envisagées avec une couche qui peut être reliée à une couche plus lointaine que la couche immédiatement précédente.

À chaque neurone est également associée une opération, c'est-à-dire un type de traitement, à effectuer par ledit neurone au sein de la couche de traitement correspondante.

Chaque couche est reliée aux autres couches par une pluralité de synapses. Un poids synaptique est associé à chaque synapse, et chaque synapse forme une liaison entre deux neurones. C'est souvent un nombre réel, qui prend des valeurs positives comme négatives. Dans certains cas, le poids synaptique est un nombre complexe.

Chaque neurone est propre à effectuer une somme pondérée des valeur(s) reçue(s) de la part des neurones de la couche précédente, chaque valeur étant alors multipliée par le poids synaptique respectif de chaque synapse, ou liaison, entre ledit neurone et les neurones de la couche précédente, puis à appliquer une fonction d'activation, typiquement une fonction non-linéaire, à ladite somme pondérée, et à délivrer en sortie dudit neurone, en particulier aux neurones de la couche suivante qui lui sont connectés, la valeur résultant de l'application de la fonction d'activation. La fonction d'activation permet d'introduire une non-linéarité dans le traitement effectué par chaque neurone. La fonction sigmoïde, la fonction tangente hyperbolique, la fonction de Heaviside sont des exemples de fonction d'activation.

En complément facultatif, chaque neurone est également apte à appliquer, en outre, un facteur multiplicatif, également appelé biais, à la sortie de la fonction d'activation, et la valeur délivrée en sortie dudit neurone est alors le produit de la valeur de biais et de la valeur issue de la fonction d'activation.

Dans l'exemple de la figure 3, la fonction d'activation comporte une succession de couches, à savoir 5 couches de convolution successives notées CC1 à CC5, une couche de pooling CP et deux couches linéaires CL1 et CL2.

Dans une couche de convolution, chaque neurone d'une même couche présente exactement le même schéma de connexion que ses neurones voisins, mais à différentes positions d'entrée. Le motif de connexion est appelé noyau de convolution ou, plus souvent, « *kernel* » en référence à la dénomination anglaise correspondante.

La couche de pooling CP ou couche de regroupement permet de compresser l'information obtenue en sortie de la succession de couches de convolution.

La couche de pooling CP peut opérer en moyenne ou en maximum.

La couche de pooling CP permet de sortir un vecteur en taille fixe (appelé espace latent), apte à être traité par une série de couches linéaires afin de procéder à la classification.

Les couches linéaires CL1 et CL2 servent transformer les informations des couches précédentes de l'espace latent en paramètres de configuration.

**Il** est à noter ici que d'autres architectures de réseau de neurones peuvent être considérées.

En particulier, le nombre de couches de convolution et/ou de couches linéaires peut varier.

Le réseau de neurones considéré peut également comporter des couches à base d'attention ou des couches de modèle d'espace d'état en complément des couches précédentes ou en remplacement d'une ou plusieurs de ces couches.

La phase d'utilisation vise, d'une part, à exploiter la fonction de configuration obtenue lors de la phase d'apprentissage et, d'autre part, à améliorer la fonction de configuration apprise en tenant compte des cas rencontrés lors de l'utilisation du modèle appris.

La phase d'utilisation permet ainsi de réaliser un apprentissage en continu de la fonction de configuration pour converger vers la fonction de configuration la plus adaptée au contrôle de la communication entre les deux plateformes 12 et 14.

Dans l'exemple décrit, la phase d'utilisation comporte une étape d'acquisition E40, une étape d'application E42, une étape de contrôle E44, une étape d'obtention E46 et une étape d'affinement E48.

Lors de l'étape d'acquisition E40, le système de contrôle 30 acquiert une pluralité de données environnementales.

Ces données environnementales proviennent généralement de capteurs de la première plateforme 12 avec lequel le système de contrôle 30 est en communication mais peuvent également provenir d'autres sources comme, par exemple, des images de la zone où évolue la première plateforme 12 prises par satellites ou une carte de l'environnement.

Lors de l'étape d'application E42, le système de contrôle 30 obtient des paramètres de configuration souhaités à partir de la fonction de configuration déterminée et de la pluralité de données environnementales acquises.

Plus précisément, le système de contrôle 30 applique la fonction de configuration sur la pluralité de données environnementales et des paramètres relatifs à chaque système de communication de la première plateforme 10 pour obtenir les paramètres de configuration.

Lors de l'étape de contrôle E44, le système de contrôle 30 contrôle un système de communication 18 (celui qui a été choisi dans l'exemple selon l'un des paramètres de configuration) de la première plateforme 10 pour que le système de communication 18 contrôlé soit configuré selon la configuration obtenue à l'issue de l'étape d'application E42.

Par exemple, le système de contrôle 30 est propre à envoyer une loi de commande à chaque élément du système de communication 18 à contrôler pour que l'élément opère selon les paramètres de configuration lui étant propres ou dans lesquels il intervient.

Pour être plus concret, soit on dispose de paramètres de configuration donnant les valeurs de chacun des réglages de chaque élément du système de communication 18 à contrôler soit de paramètres de configuration donnant les caractéristiques de l'onde à émettre.

Dans le premier cas, un signal de commande d'adopter le réglage demandé peut être émis alors que, dans le deuxième cas, il y a une étape intermédiaire de conversion du paramètre de configuration en valeurs de réglage des éléments.

A titre d'illustration, une puissance d'onde peut être obtenue en réglant la puissance fournie à l'antenne ou en modifiant le gain de l'amplificateur.

Une telle conversion (paramètre de configuration - valeurs de réglage) peut être réalisée au niveau du système de contrôle 30 ou d'une autre unité de commande destinée à cet usage.

Lors de l'étape d'obtention E46, le système de contrôle 30 est configuré pour obtenir une donnée de retour.

La donnée de retour est une donnée représentative de la qualité du signal de communication transmis.

Lors de l'étape d'affinement E48, le système de contrôle 30 affine la fonction de configuration pour obtenir une fonction de configuration affinée.

Cet affinement est réalisé en fonction de la donnée de retour obtenue à l'étape d'obtention par un réentraînement du réseau sur la base des nouvelles données ainsi obtenues.

Une telle étape est plus souvent désignée sous la dénomination anglaise correspondante de « *fine tuning* ».

L'affinement porte sur les hyperparamètres d'une partie des couches de la fonction de configuration.

En particulier, les dernières couches de la fonction de configuration sont concernées.

Dans l'exemple décrit, l'affinement porte ainsi sur la série de couches linéaires dédiées à la classification et/ou la dernière couche convolutionnelle précédant la couche de pooling pour obtenir efficacement une amélioration des performances de la fonction de configuration.

Selon l'exemple décrit, la phase d'utilisation est mise en œuvre de manière itérative. La fonction de configuration utilisée à une itération est la fonction de configuration affinée obtenue à l'itération précédente.

Avantageusement, l'itération suivante est mise en œuvre uniquement si un critère est respecté.

Par exemple, le critère est une comparaison entre une différence entre la donnée de retour acquise et la donnée de retour acquise à l'itération précédente et un seuil prédéfini.

Un autre critère est un nombre de communications réalisées par le système de contrôle 30.

Le procédé de contrôle permet ainsi d'assurer de pouvoir adapter la puissance du signal de communication transmis et le nombre d'amplificateurs selon un état courant du canal de transmission 24.

Le procédé repose en partie sur la qualité d'une fonction de configuration qui s'adapte à l'utilisation de la plateforme et s'améliore avec le temps.

En ce sens, le procédé de contrôle peut être vu comme un procédé de gestion des communications entre plusieurs systèmes de communication par apprentissage continu sur des données réelles.

La fonction de configuration obtenue est plus adaptée que les fonctions de propagation obtenue par des résolutions d'équation du fait qu'aucune hypothèse n'est faite sur le canal de transmission.

En outre, la fonction de configuration est très dépendante de l'environnement dans lequel la plateforme est utilisée, environnement qui ne peut être simulé facilement. L'utilisation des données acquises au cours de l'utilisation de la plateforme permet de remédier à cette difficulté à obtenir des données représentatives pour l'entraînement de la fonction de configuration.

L'obtention de cette fonction de configuration présente, en outre, l'avantage d'impliquer peu de ressources.

Pour augmenter encore la fiabilité de la fonction de configuration, une technique d'apprentissage actif peut être mise en œuvre.

Une telle technique est plus souvent désignée sous la dénomination anglaise correspondante d'« *active learning* ».

Selon un exemple particulier, un questionnaire de qualité est fourni à l'opérateur, notamment en demandant une évaluation de la phonie analogique survenue lors de la communication entre les antennes.

Cela permet d'améliorer la fonction de configuration soit en utilisant directement cette évaluation comme une donnée de retour dans le cadre de la phase d'utilisation soit ultérieurement en consultant l'historique de communication entre les plateformes 12 et 14.

En variante ou en complément, il est utile de mettre en œuvre une phase de contrôle.

La phase de contrôle cherche à contrôler les performances de la fonction de configuration.

En effet, il convient de garantir que la fonction de configuration permet d'atteindre des performances satisfaisantes et présente un fonctionnement compatible avec les contraintes d'utilisation de la plateforme 10.

Pour cela, il est possible d'obtenir une évaluation de la part des utilisateurs de la fonction de configuration (sous forme d'un score par exemple).

Une telle obtention peut être mise en œuvre de manière périodique.

Selon la valeur de l'évaluation, il est déterminé si la fonction de configuration s'améliore ou non.

Dans le cas où il y aurait une dégradation de l'évaluation correspondant à une dérive trop grande ne pouvant être régulée par un ajustement, la phase de contrôle conduit à remplacer la fonction de configuration contrôlée par une fonction de configuration antérieure présentant une meilleure évaluation.

Dans un tel mode de réalisation, cela implique que chaque fonction de configuration obtenue à une itération de la phase d'utilisation est mémorisée et conservée tout au long de l'utilisation de la fonction de configuration.

Une telle phase de contrôle permet ainsi de mieux garantir un bon contrôle.

Avec une fonction de configuration ainsi optimisée, il peut être avantageux de ne pas mettre en œuvre la phase d'apprentissage pour un autre cas d'utilisation.

Typiquement, pour une plateforme différente, au lieu d'apprendre une fonction de configuration sur des données synthétiques propre à la plateforme, il serait utilisé la fonction de configuration résultant de la mise en œuvre du procédé de contrôle sur l'autre plateforme.

Dans une variante plus élaborée, la fonction de configuration qui serait utilisée résulterait d'une agrégation de plusieurs fonctions de propagation optimisées. Un mécanisme d'apprentissage fédéré peut être utilisé.

## Revendications

1. Procédé de contrôle d'un système de communication (18) d'une plateforme (10), chaque système de communication de la plateforme (10) étant configurable selon plusieurs configurations, le procédé de contrôle comprenant les étapes suivantes :
- acquisition d'une pluralité de données environnementales,
- application d'une fonction de configuration sur la pluralité de données environnementales et des paramètres relatifs à chaque système de communication de la plateforme (10) pour obtenir des paramètres de configuration définissant une configuration pour un système de communication (18) de la plateforme (10),
la fonction de configuration ayant été obtenue par mise en œuvre d'un apprentissage pour que la communication réalisée avec la configuration obtenue en sortie de la fonction de configuration respecte au moins une contrainte prédéfinie, et
- contrôle d'un système de communication (18) de la plateforme (10) pour que le système de communication (18) contrôlé soit configuré selon la configuration obtenue à l'issue de l'étape d'application.

2. Procédé selon la revendication 1, dans lequel les paramètres de configuration comprennent un choix du système de communication (18) à contrôler lorsque la plateforme (10) comporte plusieurs systèmes de communication (18), une fréquence d'émission d'une onde par le système de communication (18) à contrôler et une puissance d'émission du système de communication (18) à contrôler et une forme d'onde du système de communication (18) à contrôler.

3. Procédé selon la revendication 1 ou 2, dans lequel, chaque système de communication (18) comprend une pluralité d'éléments, les paramètres relatifs à chaque système de communication (18) de la plateforme (10) comprennent la disposition des éléments, les pertes introduites par les éléments et les performances des éléments.

4. Procédé selon la revendication 3, dans lequel la pluralité d'éléments d'un système de communication (18) comporte une antenne, un amplificateur et un coupleur.

5. Procédé selon l'une quelconque des revendications 1 à 4, dans lequel les données environnementales sont des données météorologiques ou des données relatives à un objet évoluant dans un environnement de la plateforme (10).

6. Procédé selon l'une quelconque des revendications 1 à 5, dans lequel la fonction de configuration est obtenue par un apprentissage réalisé sur des données synthétiques.

7. Procédé selon l'une quelconque des revendications 1 à 6, dans lequel la fonction de configuration est un réseau de neurones comportant des couches de convolution, une couche de regroupement et des couches linéaires.

8. Procédé selon l'une quelconque des revendications 1 à 7, dans lequel une contrainte prédéfinie est une contrainte de limitation de la puissance émise par chaque système de communication.

9. Procédé selon l'une quelconque des revendications 1 à 8, dans lequel le procédé comporte, en outre, les étapes de :
- obtention d'au moins une donnée de retour, une donnée de retour étant une donnée représentative de la qualité de la communication, et
- affinement de la fonction de configuration en fonction de la donnée de retour obtenue, pour obtenir une fonction de configuration affinée.

10. Procédé selon la revendication 9, dans lequel les étapes du procédé sont mises en œuvre de manière itérative, la fonction de configuration utilisée à une itération étant la fonction de configuration affinée obtenue à l'itération précédente.

11. Procédé selon la revendication 10, dans lequel l'itération suivante est mise en œuvre uniquement si un critère est respecté, le critère étant une comparaison entre une différence entre la donnée de retour obtenue et la donnée de retour obtenue à l'itération précédente et un seuil prédéfini.

12. Procédé selon l'une quelconque des revendications 9 à 11, dans lequel la donnée de retour est une donnée représentative de la qualité du signal de communication transmis.

13. Système de contrôle (30) d'un système de communication (18) d'une plateforme (10), chaque système de communication de la plateforme (10) étant configurable selon plusieurs configurations, le système de contrôle (30) étant propre à :
- acquérir une pluralité de données environnementales,
- appliquer une fonction de configuration sur la pluralité de données environnementales et des paramètres relatifs à chaque système de communication de la plateforme (10) pour obtenir des paramètres de configuration définissant une configuration pour un système de communication (18) de la plateforme (10),
la fonction de configuration ayant été obtenue par mise en œuvre d'un apprentissage pour que la communication réalisée avec la configuration obtenue en sortie de la fonction de configuration respecte au moins une contrainte prédéfinie, et
- contrôler un système de communication (18) de la plateforme (10) pour que le système de communication (18) contrôlé soit configuré selon la configuration obtenue après application de la fonction de configuration.

14. Plateforme comprenant un système de contrôle selon la revendication 13.
